(19) Europäisches Patentamt
European Patent Office
Office européen des brevets

(11) EP 0 623 852 B1

(12) **EUROPEAN PATENT SPECIFICATION**

(45) Date of publication and mention of the grant of the patent:
**21.10.1998 Bulletin 1998/43**

(51) Int Cl.$^6$: **G03F 7/038**

(21) Application number: **94107156.5**

(22) Date of filing: **06.05.1994**

(54) **Resist compositions for circuit boards**

Resistzusammensetzungen für gedruckte Schaltungen

Compositions formant réserve pour circuits imprimés

(84) Designated Contracting States:
**DE GB NL**

(30) Priority: **07.05.1993 JP 106406/93**

(43) Date of publication of application:
**09.11.1994 Bulletin 1994/45**

(60) Divisional application: **97110145.6 / 0 802 456**

(73) Proprietor: **IBIDEN CO, LTD.**
**Ogaki-shi Gifu 503 (JP)**

(72) Inventors:
- **Kawade, Masato, c/o Ibiden Co., Ltd. Ibi-gun, Gifu (JP)**
- **Asai, Motoo, c/o Ibiden Co., Ltd. Ibi-gun, Gifu (JP)**

(74) Representative: **Grünecker, Kinkeldey, Stockmair & Schwanhäusser Anwaltssozietät**
**Maximilianstrasse 58**
**80538 München (DE)**

(56) References cited:
**DE-A- 3 717 199** **US-A- 5 175 060**

- **PATENT ABSTRACTS OF JAPAN vol. 014, no. 001 (P-985) 8 January 1990 & JP-A-01 253 730 (IBIDEN CO LTD) 11 October 1989**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

### BACKGROUND OF THE INVENTION

#### Field of the Invention

This invention relates to a printed circuit board and more particularly to a circuit board comprising a cured resist having excellent resistance to alkali and thermal resistance without degrading photosensitive properties.

#### Description of the Related Art

Recently, the miniaturization and high-speed performance of electronic parts and equipments are proceeding with the advance of electronics industry. For this end, a printed circuit board as well as a circuit board mounting LSI are required to have a high densification and a high reliability through a fine pattern.

Lately, an additive process in which an adhesive is applied onto a surface of a substrate to form a resin insulating layer, and the surface of the resin insulating layer is roughened and then subjected to an electroless plating to form a conductor is noticed as the other method of forming the conductor onto the printed wiring substrate.

According to this method, the conductor is formed by electroless plating after the formation of the resist, so that it has a merit that a conductor wiring having high density and pattern accuracy can be produced with a low cost as compared with an etched foil process conducting the formation of pattern through etching (which is called as a subtractive process).

In order to produce circuits having a higher density and a higher pattern precision by such an additive process at a low cost, it is particularly important to select a resist. That is, it is necessary to use a resist composition which can stick to a surface of a roughened adhesive layer, with a good followability and has a high resolution and does not leave a residue of a developer on the considerably roughened surface after the development and also provides less of an elute component even after the immersion in a high alkali bath at a high temperature for a long time.

As the resist composition for a circuit board satisfying these requirements, compositions having a resolution obtained by combining a binder polymer having an average molecular weight above about hundreds of thousands such as PMMA or the like with an acryl oligomer or acryl monomer having a photosensitive group are widely used in view of film-forming property, resistance to plating bath and thermal resistance.

However, the resist composition for a circuit board composed mainly of the above polymer has drawbacks that, since the average molecular weight of the polymer as a main component is hundreds of thousands, the resulting cured resist has a low crosslinking density and when it is immersed in a high-temperature high alkali bath for plating or the like, it swells due to penetration of alkali. As a result, a great amount of the cured resist during the plating is eluted into the plating solution due to hydrolysis reaction with alkali. The problem caused by the low resistance to alkali is that the plating solution and the properties of the plated film are degraded.

As a technique for improving the resistance to alkali of the cured resist, there is proposed, for example, a resist ink composition for electroless metal plating comprising an epoxy resin, an aromatic amine curing agent for epoxy resin and an imidazole curing agent for epoxy resin as an essential ingredient and ic containing an organic solvent, a thixotropic agent, a filler and a chemical plating inhibitor (Japanese Patent laid open No. 57-90072).

This technique is concerned with a resist ink for protecting a conductor pattern in a semi-additive process. Such a resist ink is sufficiently durable even when being immersed in an alkali bath of pH = 12-13 (20°C).

However, this resist ink is not sufficiently durable to a plating other than electroless copper plating, e.g. electroless solder plating when being immersed in an alkali bath having a pH of not less than 14 and a bath temperature of 80°C for not less than 5 hours. Furthermore, the resist ink is a thermosetting resin composition, so that it can not be applied to the formation of a printed circuit board through an additive process requiring the photosensitive property of the resist composition.

Moreover, a photosensitive resin composition containing a half ester of novolac epoxy resin partly acrylated as a base material is proposed as a technique of using a resin having a thermosetting property and a photosensitivity in the resist composition (Japanese Patent laid open No. 61-59447).

According to this technique, a resist having an excellent photosensitivity and heat resistance can be obtained.

However, the composition of the resins according to the latter technique has a problem that a cured resist sufficiently durable to an alkali bath having a pH of not less than 14 at a bath temperature of 80°C cannot stably be obtained without degrading the photosensitivity.

### SUMMARY OF THE INVENTION

It is, therefore, an object of the invention to solve the above problems in the conventional resist compositions and

to develop a resist composition for a circuit board having an excellent heat resistance and capable of stably providing a cured resist sufficiently durable to an alkali bath having a pH of not less than 14 and a bath temperature of 80°C without degrading photosensitivity and hence to provide a printed circuit board having an excellent reliability even in fine patterns.

Said object is achieved by a printed circuit board comprising a given conductor pattern and resist for plating formed on an adhesive layer on a substrate, characterized in that the resist for plating is formed by curing an uncured novolac type epoxy resin having a structure of formula (1) acrylated at an acrylating ratio of 20-80% and containing 2-8% by weight, based on the photosensitive resin matrix, of an imidazole curing agent, and has a water absorption ratio of not more than 0.1% after the curing.

Formula (1)

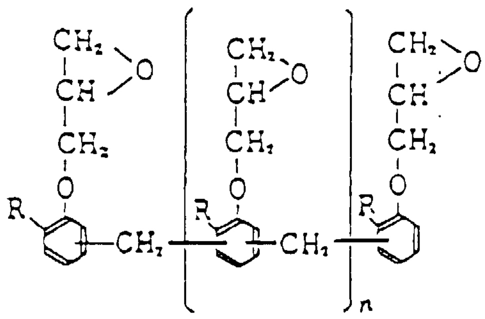

R=H or $CH_3$

The photosensitive resin composition used in a resist for the circuit board generally contains a (meth)acrylate monomer, oligomer or polymer represented by $CH_2$=$CR_1COOR_2$ or (-$CH_2$-$CR_1COOR_2$-)n as an essential component in view of photosensitivity. The cured product obtained by the crosslinking reaction of this component comprising an ester structure of >C- $COOR_2$.

Further, it is known that the resin having the above ester structure is subject to the hydrolysis shown by the following reaction formula in the presence of an alkali:

$$>C\text{-}COOR_2 + OH^- \rightarrow >C\text{-}COO^- + R_2OH$$

Moreover, the above resin composition is required to use an epoxy resin as a base resin in view of the heat resistance.

With the foregoing in mind, the inventors have made various studies with respect to the composition of the resist composition for attaining the object and have found a new resist composition for a circuit board capable of suppressing esterification during the curing and reducing molecular weight between crosslinking points in the cured product, and as a result the invention has been accomplished.

That is, the resist composition for a circuit board according to the invention is characterized by using an uncured novolac type epoxy resin having a structure of formula (1), preferably having an epoxy equivalent of not more than 300, a part of epoxy groups of which is acrylated, as a resin component of a photosensitive resin matrix and adding an imidazole curing agent. In this composition, an acrylating ratio of the epoxy group in the uncured novolac type epoxy resin is 20-80% and the amount of the imidazole curing agent added is 2-8 % by weight based on the photosensitive resin matrix.

A printed circuit board according to the invention is a circuit board comprising a given conductor pattern and resist for plating formed on an adhesive layer on a substrate and is characterized by curing the aforementioned resist composition to form a resist. In the circuit board, a water absorbing ratio of the cured resist is not more than 0.1%.

## BRIEF DESCRIPTION OF THE DRAWING

The invention will be described with reference to the accompanying drawing, wherein:

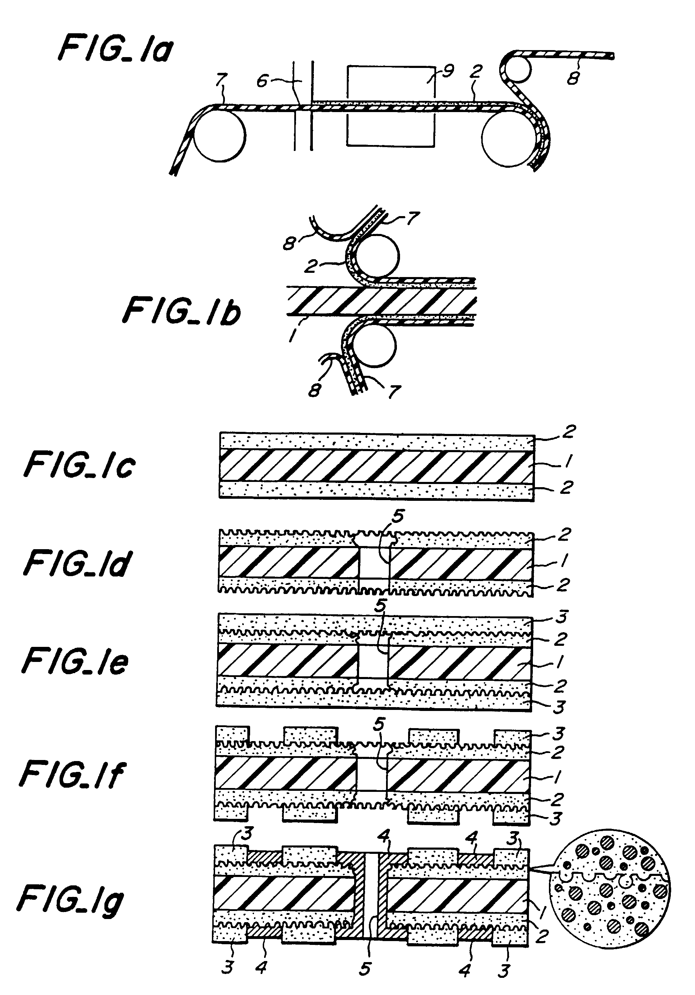

Fig. 1 is a flow chart of producing a printed circuit board according to the invention.

DESCRIPTION OF THE PREFERRED EMBODIMENTS

Firstly, in the resist composition for a circuit board according to the invention an an uncured novolac type epoxy resin, a part of epoxy groups of which is acrylated, is included as a resin component of a photosensitive resin matrix, whereby the molecular weight between crosslinking points in the cured product can be reduced with maintaining the photosensitivity. Thus, the penetration of alkali in the high alkali treatment at a high temperature can effectively be prevented to improve the resistance to alkali.

The novolac type epoxy resin is a structure in which an epoxy group as a functional group and a benzene ring form a repeating unit as shown in the following general formula (1):

Formula (1)

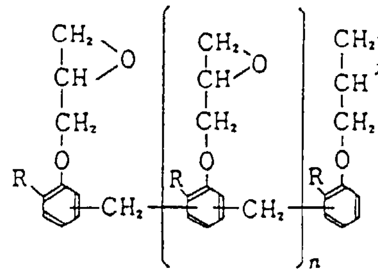

R = H or $CH_3$

and has the same number of benzene rings as the number of functional crosslinking groups and also is not a long-chain high polymer, so that the cured product thereof has a great number of crosslinking points and benzene rings per unit volume. As a result, it is considered that the molecule motion under high alkali at a high temperature can be controlled to prevent the penetration of alkali and hence $OH^{\ominus}$ group hardly reacts with the polar group in the cured product.

Secondly, in the resist composition used in the invention the imidazole is added as a curing agent for the epoxy resin. Thus, it is possible to control the esterification in the curing of the composition and hence the hydrolysis reaction through alkali is prevented which improves the resistance to alkali.

Concretely, when acid anhydride is used as a curing agent, there is caused a curing reaction as shown in the following reaction scheme (2):

Reaction scheme (2)

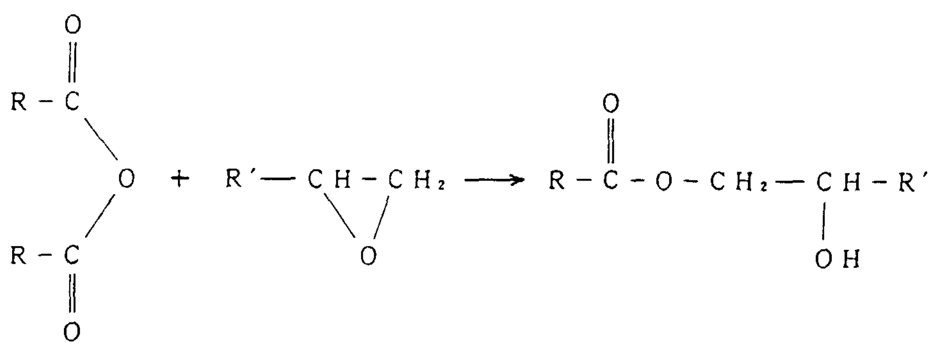

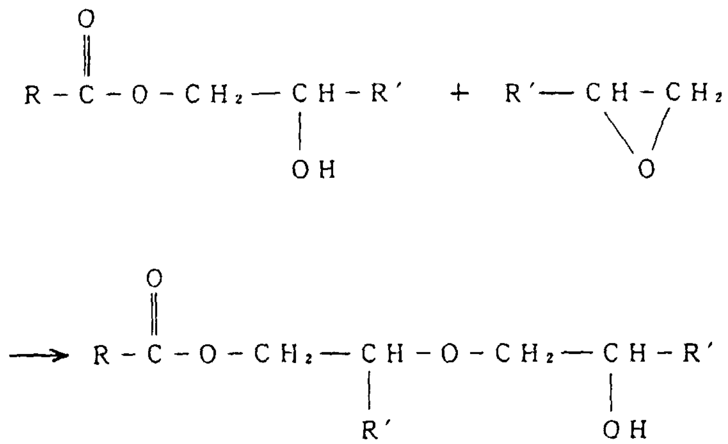

The cured product obtained in this reaction is hydrolyzed in an alkali bath as shown in the following reaction scheme (3):

Reaction scheme (3)

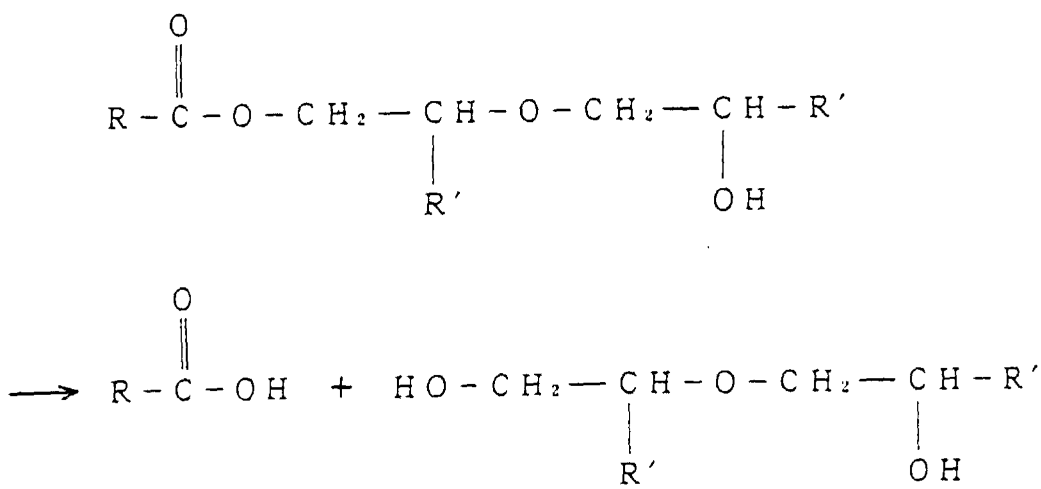

That is, it is considered that the cured resin is apt to be subjected to the hydrolysis reaction caused by alkali since the polarity is high and the polarization is vigorous, and the resistance to alkali becomes poor.

In this connection, the imidazole curing agent used as the curing agent for the epoxy resin shows the following reaction scheme (4), so that it is considered that the resulting cured product does not newly form an ester structure and becomes very stable in the alkali bath:

Reaction scheme (4)

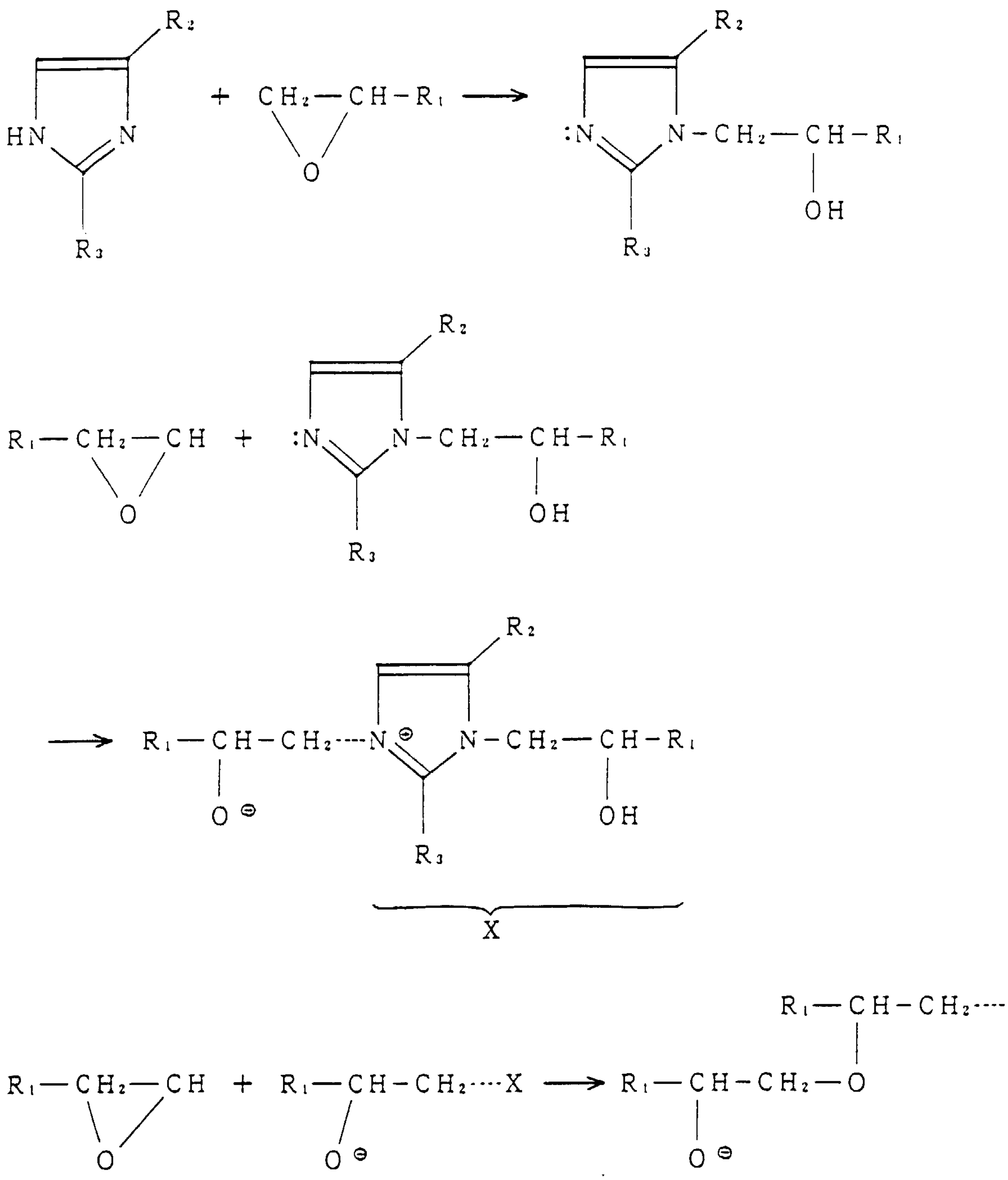

As mentioned above, the resist composition for a circuit board according to the invention can provide a cured resist having an excellent heat resistance and capable of sufficiently enduring an alkali bath having a pH of not less than 14 at a bath temperature as high as 80°C without degrading the photosensitive property. Consequently, the invention can easily provide a printed circuit board having an excellent reliability even in fine pitch pattern.

In the uncured novolac type epoxy resin constituting the photosensitive resin matrix for the resist composition used in the invention, in order to simultaneously establish high resolution (photosensitive property) and resistance to alkali, a part of the epoxy resin is acrylated as a resin component in the photosensitive resin matrix. That is, the acrylation ratio of the epoxy group is 20-80%, preferably 25-50% for satisfying the photosensitive property (resolution) of the resist, while the resistance to alkali in the resist may be improved by using the novolac type epoxy resin as a resin component.

The reason why the acrylation ratio of the epoxy group is limited to a range of 20-80% is due to the fact that when

it is less than 20%, the developability of the resist is poor and it is difficult to form a fine pitch pattern, while when it exceeds 80%, the sufficient resistance to alkali is not obtained.

The acrylation of the epoxy group is conducted by using an acryloyl group ($CH_2$=CHCO-) or a, methacryloyl group ($CH_2$=C($CH_3$)CO-).

The uncured novolac type epoxy resin preferably is a resin having an epoxy equivalent of not more than 300, more preferably not more than 250. When the epoxy equivalent is more than 300, the molecular weight between the crosslinking points in the cured epoxy resin is large and the penetration of alkali is easy and the degradation of the resistance to alkali is caused.

The term "epoxy equivalent" used in the invention means gram number including 1 g equivalent of epoxy group.

According to the invention, not less than 50% by weight, preferably not less than 70% by weight of the novolac type epoxy resin having such functional group is included as a resin component in the photosensitive resin matrix. When the content of the novolac type epoxy resin is less than 50% by weight, the molecular weight between the crosslinking points in the cured resist can not sufficiently be reduced.

According to the invention, the photosensitive resin matrix may include a thermosetting resin, a thermoplastic resin, a photosensitive resin, a photoinitiator, a curing agent as constituting components other than the novolac type epoxy resin such as a cresol novolac type epoxy resin, a phenol novolac type epoxy resin or the like and may contain a co-photoinitiator if necessary.

As the thermosetting resin, use may be made of an epoxy resin, allyl resin, melamine resin, urea resin.

As the thermoplastic resin, use may be made of polyether sulfone, polyether imide, phenoxy resin.

As the photosensitive resin, use may be made of the conventionally known monofunctional or polyfunctional photosensitive resins having a molecular weight of not more than 10,000.

The thermosetting or photosensitive resin may advantageously be used as the molecular weight between the crosslinking points through thermosetting or photocuring becomes small.

As the photo initiator, use may be made of at least one intramolecular linkage opening type or intermolecular hydrogen pulling type substance selected from benzoisobutyl ether, benzildimethyl ketal, diethoxy acetophenone, acyloxyme ester, chlorinated acetophenone, hydroxyacetophenone, benzophenone, Michler's ketone, dibenzosuberone, 2-ethylanthraquinone, isobutyl thioxanthane.

As the co-photoinitiator, use may be made of at least one amine selected from triethanol amine, methyldiethanol amine, triisopropanol amine, Michler's ketone, 4,4'-diethylamino benzophenone, 2-dimethylamino ethyl benzoic acid, 4-dimethylamino benzoic acid ethylester, 4-dimethylamino benzoic acid isoamylester, 4-dimethylamino benzoic acid 2-ethylhexylster, polymerizable tertiary amine.

In the invention, the imidazole curing agent for the epoxy resin is added to the matrix in an amount of 2-8% by weight. When the amount exceeds 8% by weight, the water absorption ratio of the cured product rises owing to the high water absorption ratio of the imidazole compound itself and hence the resistance to alkali rather lowers, while when it is less than 2% by weight, the curing is insufficient and the crosslinked density of the cured product becomes small and the desired resistance to alkali is not obtained.

As the photosensitive resin matrix in the resist composition for a circuit board according to the invention, the resin containing no solvent may be used as it is. Moreover, a solution of the resin in a solvent can advantageously be used because the adjustment of the viscosity and the formation of the film are easy.

As the solvent for the resin, mention may be made of methyl ethyl ketone, methyl cellosolve, ethyl cellosolve, butyl cellosolve, butyl cellosolve acetate, butyl carbitol, butyl cellulose, tetralin, dimethyl formamide, normal methylpyrrolidone and the like.

Furthermore, the photosensitive resin matrix may properly be compounded with a coloring agent (pigment), a leveling agent, an anti-foaming agent, a ultraviolet ray absorbing agent, a flame retardant, heat-resistant fine particles, other filler and the like.

Especially, the heat-resistant fine particles dispersed into the uncured photosensitive resin matrix are preferably previously cured heat-resistant resin fine particles or inorganic fine particles from a viewpoint that they are required to be excellent in the heat resistance and the electric insulation and stable against usual chemicals. For example, epoxy resin, melamine resin, phenolic resin and the like are used as the previously cured heat-resistant fine particle, and silica, Teflon® and the like are preferably used as the inorganic fine particle.

The particle size of the heat-resistant fine particles is preferably not more than 10 μm on average, particularly 0.5-5 μm. When the average particle size is more than 10 μm, the followability is difficult in the application to the fine and uneven surface of the adhesive layer and it is difficult to obtain a fine conductor pattern.

As shown in Fig. la, the resist composition for a circuit board according to the invention is applied onto a base film through roll coater, doctor bar or the like and dried in a drying furnace set at 60-100°C to remove a given amount of the solvent, whereby a film at B-stage state is formed in view of the uniformity of film thickness and the productivity. In this case, the thickness of the resist on the base film is adjusted to 15-150 μm by a gap of the doctor bar. Since the resist film is wound into a coil form, it is desirable to protect the resist in the uncured state by forming a protection film

(cover film) on the resist.

As the base film, there are preferably used films of polyethylene terephthalate, polypropylene, polyethylene fluoride (Tedlar® film) and the like. The thickness of the base film is desirably 5-100 µm. In order to prevent flicking of the plating resist from the base film, the surface of the base film to be coated may be subjected to a mud treatment (unevenness treatment). Furthermore, in order to prevent the occurrence of struck damage and recess of the resist layer through foreign matter during the contact between sheets in the preparation of the resist film, the non-coated surface may also be subjected to the mud treatment. Moreover, in order to facilitate the peeling removal of the base film, the contact surface with the resist layer may be subjected to a releasing treatment with silicon.

And also, the resist film used in the invention can directly be produced without using the base film.

An example of producing a printed circuit board by using the resist for a circuit board of the invention will be described below.

First, an adhesive layer is formed on a surface of a substrate such as glass epoxy substrate, polyimide substrate, ceramic substrate, metal substrate or the like according to a usual manner and then the surface of the adhesive layer is roughened by using an acid or an oxidizing agent in the usual manner and thereafter a catalyst is fixed to the roughened surface of the adhesive layer.

As an adhesive constituting the adhesive layer, there is preferably used a so-called additive adhesive formed by dispersing a resin filler into a resin matrix. The matrix is desirable to be a photosensitive resin. The resin filler is desirable to be selected from (1) particles having an average particle size of not more than 10 µm, (2) agglomerate particles having an average particle size of 2-10 µm through agglomeration of heat-resistant resin powder having an average particle size of not more than 2 µm, (3) mixed particles of heat-resistant resin powder having an average particle size of 2-10 µm and heat-resistant resin powder having an average particle size of not more than 2 µm and (4) false particles obtained by adhering at least one of heat-resistant resin powder having an average particle size of not more than 2 µm and inorganic powder having an average particle size of not more than 2 µm to surfaces of heat-resistant powder having an average particle size of 2-10 µm.

Furthermore, an anchor recess formed in the roughened adhesive layer is desirable to have an average depth of not more than 15 µm, whereby a conductor pattern can be rendered into a fine pitch pattern having L/S of not more than 50/50 (µm).

Then, the resist film used in the invention is stuck to the roughened surface of the adhesive layer and laminated through heating under pressure.

Thereafter, the resulting laminate is subjected to exposure, development, UV curing and heat treatment, whereby a resist printed into a given pattern is formed.

When a composition obtained by dispersing heat-resistant fine particles into a heat-resistant photosensitive resin matrix is applied to a base film to form a resist for a circuit board, after the base film is peeled off, the resist is subjected to exposure, development, UV curing and heat treatment to form a given print pattern.

Next, the catalyst is activated through an acid treatment and electroless plating is carried out to form a necessary conductor pattern, whereby a desired printed circuit board is obtained.

The thus obtained printed circuit board according to the invention is a printed circuit board comprising a given conductor pattern and a resist for plating formed on an adhesive layer on a substrate in which the resist is formed by curing the resist composition for a circuit board according to the invention. In the printed circuit board, the water absorption ratio of the cured resist is not more than 0.1%, preferably not more than 0.05%. When the water absorption ratio is not more than 0.1%, the crosslinking density is high and the nucleophilic attack of $OH^-$ cannot be attained and hence the decomposition of the resin hardly occurs.

The measurement of water absorption ratio is conducted by immersing a thin sheet having a square of 5 cm as a test specimen in a boiling water of 100°C for 1 hour and then measuring a weight change.

The following examples are given in illustration of the invention and are not intended as limitations thereof.

<u>Example 1</u>

(1) A glass epoxy insulating substrate 1 buff-polished so as to have a surface roughness of 3 µm is preheated to a surface temperature of 60°C and then adhesive sheets prepared according to the following steps (i) - (vii) are heat-pressed at 80°C to both surfaces of the substrate so as to face a resin layer 2 to the substrate while peeling off a polyethylene film 8 from the adhesive sheet (see Figs. 1a-1b).

(i) A resin solution is prepared by dissolving 10 parts by weight of cresol novolac type epoxy resin (molecular weight: about 4,000, melting point: 85°C), 50 parts by weight of phenol novolac type epoxy resin (molecular weight: about 1,000, melting point: 28°C) and 40 parts by weight of bisphenol A-type epoxy resin (molecular weight: about 1,500, melting point: 70°C) into MEK.

(ii) A suspension is prepared by adding 10 parts by weight of fine particles of epoxy resin (particle size: 0.5 µ

m) into 30 parts by weight of MEK and dispersing therein under ultrasonic.

(iii) The resin solution of the step (i) is added to the suspension of the step (ii) five times, in which the resulting solution is passed through sand mill containing zirconia balls of 2 mm in diameter at a flow rate of 0.5 l/min every one time.

(iv) To the resin solution of the step (iii) are added 25 parts by weight of fine particles of epoxy resin (particle size: 5 μ m) and 5 parts by weight of imidazole curing agent, which are mixed in sand mill.

(v) To 100 parts by weight of the resin solution of the step (iv) are added 0.2 part by weight of leveling agent and 0.3 part by weight of anti-foaming agent, which are mixed in a Homodisper® to obtain an adhesive solution having a solid content of 70%, viscosities of 1.50 Pa·s at 6 rpm and 0.30 Pa·s at 60 rpm and a thixotropy of 5.0.

(vi) The adhesive solution of the step (v) is applied onto a polypropylene film 7 of 40 μ m in thickness subjected to a mud treatment through a doctor blade 6 and dried in a hot circulation furnace at 80°C for 5 minutes to form a resin layer having a thickness of 40 μ m and a solvent remaining ratio of 1.5%.

(vii) A polyethylene film 8 is hot-pressed onto the resin layer of the step (vi) to form an adhesive sheet of three layer structure.

(2) After the polypropylene film 7 is peeled off from the surface, the resin layer is cured by subjecting to a heat treatment at 120°C for 2 hours and at 150°C for 1 hour to form an adhesive layer 2. The adhesive layer 2 has a glass transition temperature (Tg) of 170°C as measured by means of a viscoelastic spectrometer (see Fig. 1c).

(3) The surface of the adhesive layer 2 formed on the substrate 1 at the step (2) is roughened by immersing in an aqueous solution of 800 g/l of anhydrous chromic acid at 70°C (ratio of $Cr^{3+}$ in total Cr is 0.50%). The roughened surface has a surface roughness of Rz = 12 μ m and Ra = 2.0 μ m.

(4) After the surface roughening, the adhesive layer is washed with water and immersed in an aqueous solution of 400 g/l of sodium sulfite at room temperature for 20 minutes to conduct neutralization of $Cr^{6+}$. After the washing with water, it is washed with hot water at 70°C for 20 minutes and further with water and dried at 80°C for 10 minutes.

(5) The thus treated substrate is pierced according to usual manner to form through-holes 5, which are washed with water under a high pressure of 5 kg/cm$^2$ (see Fig. 1d).

(6) The substrate 1 is degreased according to usual manner, subjected to a hydrophilic treatment with a surfactant and an acid treatment and then a colloid catalyst of Pd-Sn is applied and an acid treatment is again carried out to remove unnecessary Sn. The amount of Pd adhered to the surface is 5 μ g/cm$^2$.

(7) After the provision of the catalyst, the catalyst nucleus is fixed to the surface by heat treatment at 120°C for 40 minutes.

(8) The substrate 1 is preheated to 80°C and then a resist film (dry film resist) prepared according to the following steps (i)-(iv) is hot pressed thereto at 100°C, which is subjected to light exposure, development, UV curing and heat treatment according to usual manner to form a resist 3. In this case, 1,1,1-trichloroethane is used as a developing agent (see Fig. 1e).

(i) A resin solution is prepared by dissolving 65 wt% of 50% acrylated product of cresol novolac type epoxy resin (molecular weight: about 4,000, epoxy equivalent: 220, melting point: 90-95°C), 16 wt% of bisphenol A-type epoxy resin (molecular weight: about 900, epoxy equivalent: 450, melting point: 60-75°C), 3 wt% of dipentaerythritol hexaacrylate (molecular weight: about 300) and 3 wt% of neopentyl glycol-modified trimethylol propane diacrylate (molecular weight: about 300) in BCA.

(ii) The resin solution of the step (i) is added with 5 wt% of benzophenone, 1 wt% of Michler's ketone and 6 wt% of imidazole curing agent, which are mixed in a sand mill.

(iii) The resin solution of the step (ii) is added with 1 wt% of acrylic leveling agent, which are mixed in a Homodisper® agitating machine to obtain a photosensitive resin solution having a solid content of 65 wt%.

(iv) The photosensitive resin solution of the step (iii) is applied to a polypropylene film of 15 μm in thickness subjected to a mud treatment through a doctor blade and dried in a hot circulation furnace at 80°C for 5 minutes to obtain a sheet-like resist film having a thickness of 40 μm and a residual solvent ratio of 1.5 wt%.

(9) After the catalyst is activated by an acid treatment, it is immersed in an electroless copper plating solution having a composition shown in Table 1 according to the usual manner for 11 hours to obtain an electroless copper plated film 4 having a thickness of 25 μm. In this case, the stepwise difference in the conductor pattern between resist 3 and plated film 4 is 5 μm.

Table 1

| | |
|---|---|
| copper sulfate | 0.06 mol/l |
| formalin (37%) | 0.30 mol/l |

Table 1 (continued)

| | |
|---|---|
| sodium hydroxide | 0.35 mol/l |
| EDTA | 0.35 mol/l |
| additive | few |
| plating temperature | 70-72°C |
| pH | 12.4 |

(10) A solder resist is formed on the plated film according to the usual manner to produce a printed circuit board.

Example 2

A sheet-like resist having the following composition is prepared in the same manner as in Example 1 and a printed circuit board is produced by using such a resist.

| | |
|---|---|
| 25% acrylated product of cresol novolac type epoxy resin (epoxy equivalent:205): | 57 wt% |
| polyether sulfone: | 23 wt% |
| dipentaerythritol tetraacrylate: | 5 wt% |
| neopentylglycol-modified trimethylol propanediacrylate: | 2 wt% |
| benzophenone: | 4 wt% |
| Michler's ketone: | 1 wt% |
| imidazole curing agent: | 3 wt% |
| acrylic leveling agent: | 0.1 wt% |
| fine particles of benzoguanamine resin: (particle size: 2 μ m, made by Nippon Shokubai Kagaku K.K.) | 4.9 wt% |

Example 3

A sheet-like resist having the following composition is prepared in the same manner as in Example 1 and a printed circuit board is produced by using such a resist.

| | |
|---|---|
| 70% acrylated product of phenol novolac type epoxy resin (epoxy equivalent:180): | 50 wt% |
| modified bisphenol A-type epoxy resin: | 10 wt% |
| pentaerythritol hexaacrylate: | 3 wt% |
| neopentylglycol diacrylate: | 3 wt% |
| benzophenone: | 4 wt% |
| Michler's ketone: | 0.4 wt% |
| imidazole curing agent: | 5 wt% |
| acrylic leveling agent: | 0.6 wt% |
| silica fine particles: (particle size: 1 μ m, made by Admatex Co., Ltd.) | 24 wt% |

Example 4

A sheet-like resist having the following composition is prepared in the same manner as in Example 1 and a printed circuit board is produced by using such a resist.

| | |
|---|---|
| 25% acrylated product of cresol novolac type epoxy resin (epoxy equivalent:230): | 67 wt% |
| bisphenol A-type epoxy resin: | 12 wt% |
| dipentaerythritol hexaacrylate: | 5 wt% |
| neopentylglycol diacrylate: | 2 wt% |
| 2-methyl-1-(4-(methylthio) phenyl)-2-morpholino-propane-1-one (made by Ciba Geigy Co., Ltd.) | 5 wt% |
| 2,4-diethylthioxanethane (made by Nippon Kayaku K.K.) | 1 wt% |
| imidazole curing agent: | 7 wt% |
| acrylic leveling agent: | 1 wt% |

Comparative Example 1

A sheet-like resist having the following composition is prepared in the same manner as in Example 1 and a printed circuit board is produced by using such a resist.

| | |
|---|---|
| 50% acrylated product of cresol novolac type epoxy resin: | 53 wt% |
| bisphenol A-type epoxy resin: | 15 wt% |
| dipentaerythritol hexaacrylate: | 3 wt% |
| neopentylglycol-modified trimethylol propane diacrylate: | 3 wt% |
| benzophenone: | 4 wt% |
| Michler's ketone | 1 wt% |
| acid anhydride curing agent: | 20 wt% |
| acrylic leveling agent: | 1 wt% |

Comparative Example 2

A sheet-like resist having the following composition is prepared in the same manner as in Example 1 and a printed circuit board is produced by using such a resist.

| | |
|---|---|
| polymethyl methacrylate: | 55 wt% |
| bisphenol A-type epoxy resin: | 10 wt% |
| dipentaerythritol hexaacrylate: | 10 wt% |
| neopentylglycol-modified trimethylol propane diacrylate: | 15 wt% |
| benzophenone: | 4 wt% |
| Michler's ketone | 1 wt% |
| imidazole curing agent: | 20 wt% |
| acrylic leveling agent: | 1 wt% |

In the production of printed circuit boards as mentioned above, the evaluation of the resistance to alkali in each plated resist is carried out by a contaminant test for the plating bath in which properties of copper plated film (elongation, resistivity) are measured in the plated baths after 3 turns and 6 turns.

In order to evaluate the applicability of the resist to the bath at higher temperature and higher pH, the presence or absence of color change in the bath due to an ingredient eluted from the bath and the surface state of the resist are measured by immersing the resist in an alkali bath at 80°C and pH = 14 for 6 hours.

Furthermore, the water absorption ratio of the resist is measured.

The evaluation results are shown in Table 2. As seen from Table 2, the resist compositions used for a circuit board according to the invention are excellent in all properties as compared with the comparative examples containing no novolac type epoxy resin or no imidazole curing agent.

Table 2

| | | Contaminant test for plating bath | | Immersion test Water in alkali bath at 80°C and pH = 14 | | Water tion ratio of cured resist (%) |
|---|---|---|---|---|---|---|
| | | 3 turns | 6 turns | Color change of bath due to ingredient eluted from resist | Surface state | |
| Example | 1 | 2.1% | 4.1% | none | smooth | 0.02 |
| | 2 | 2.0% | 3.9% | none | smooth | 0.02 |
| | 3 | 1.9% | 3.8% | none | smooth | 0.008 |
| | 4 | 2.2% | 4.1% | none | smooth | 0.04 |

Table 2 (continued)

| | | Contaminant test for plating bath | | Immersion test Water in alkali bath at 80°C and pH = 14 | | Water tion ratio of cured resist (%) |
|---|---|---|---|---|---|---|
| | | 3 turns | 6 turns | Color change of bath due to ingredient eluted from resist | Surface state | |
| Comparative Example | 1 | 18 % | 53 % | presence | occurrence of unevenness due to elution | 0.2 |
| | 2 | 29 % | 62 % | presence | occurrence of unevenness due to elution | 0.3 |

Moreover, the resistance to alkali in the resist composition for a circuit board and the water absorption ratio of the cured resist are evaluated as follows:

(1) Resistance to alkali

The degradation ratio of the properties (elongation, resistivity) in the copper plated film after 3 and 6 turns are measured by a contaminant test in the plating bath as mentioned below.

(i) As an initial value, the plating is carried out in the plating bath at 70°C and pH = 12 as described in the Examples to measure the properties of the resulting copper plated film (measured value $\alpha$ ).

(ii) A contaminant bath is intentionally prepared by adding the same amount of resist ingredient as that in the bath after 3 or 6 turns, and then rendered into the same plating bath as described in Examples, and thereafter the plating is carried out in this plating bath to measure the properties of the resulting copper plated film (measured value $\beta$).

(iii) The resistance to alkali is evaluated by determining a value of $\{(\alpha - \beta)/\alpha\} \times 100$.

In Table 2, the resistance to alkali is shown by the value of $\{(\alpha - \beta)/\alpha\} \times 100$.

(2) Water absorption ratio of cured resist

It is evaluated according to JIS K7209 by the following method.

(i) A test piece has a square of 50 ± 1 mm and a thickness of not more than 25 mm. When the thickness is more than 25 mm, it is reduced to not more than 25 mm by polishing. Moreover, the scattering of the thickness is ignored because of the μm order. Since the plated resist cannot be cut out into a square of 50 ± 1 mm, the test piece is cut out so as to have a total area of 25 $cm^2$.

(ii) The test piece is put into a thermostatic vessel held at 50 ± 2°C and dried for 24 ± 1 hours and cooled in a desiccator to measure the weight of the test piece up to the order of 0.1 mg, which is M1.

(iii) Then, the test piece is immersed in a boiling water for 30 ± 1 minutes and cooled in water held at room temperature for 15 ± 1 minutes and thereafter taken out from water to measure the weight of the test piece up to the order of 0.1 mg, which is M2.

(iv) The water absorption ratio(%) (%) is evaluated by a value of {(M2- M1)/M1} x 100. .

As mentioned above, according to the invention, cured resists having an excellent heat resistance and capable of sufficiently withstanding to an alkali bath at pH of not less than 14 and a bath temperature of 80°C can stably be provided without degrading photosensitive properties. As a result, printed circuit boards having an excellent reliability can easily be obtained even in a fine pitch pattern.

## Claims

**1.** A printed circuit board comprising a given conductor pattern and resist for plating formed on an adhesive layer on

a substrate, characterized in that the resist for plating is formed by curing an uncured novolac type epoxy resin having a structure of formula (1) acrylated at an acrylating ratio of 20-80% and containing 2-8% by weight, based on the photosensitive resin matrix, of an imidazole curing agent, and has a water absorption ratio of not more than 0.1% after the curing.

Formula (1)

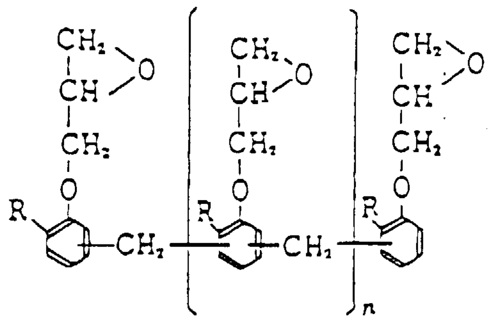

R = H or $CH_3$

2. The printed circuit board according to claim 1, characterized in that said uncured novolac type epoxy resin has an epoxy equivalent of not more than 300.

**Patentansprüche**

1. Leiterplatte, umfassend ein vorgegebenes Leiterbild und einen Resist zum Plattieren, der auf einer Klebstoffschicht auf einem Substrat gebildet ist, **dadurch gekennzeichnet, daß** der Resist zum-Plattieren durch Härten eines ungehärteten Novolak-Epoxyharzes mit einer Struktur der Formel (1), welches mit einem Acrylierungsverhältnis von 20-80% acryliert ist und 2-8 Gew.-%, bezogen auf die lichtempfindliche Harzmatrix, eines Imidazol-Härtungsmittels enthält, gebildet ist und ein Wasserabsorptionsverhältnis von nicht mehr als 0,1% nach dem Härten aufweist.

Formel (1)

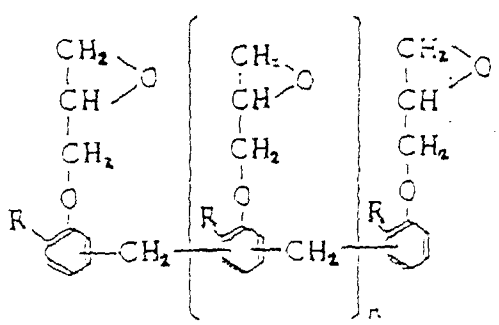

R=H oder $CH_3$

2. Leiterplatte nach Anspruch 1, **dadurch gekennzeichnet, daß** das ungehärtete Novolak-Epoxyharz ein Epoxyäquivalent von nicht mehr als 300 aufweist.

**Revendications**

1. Carte à circuit imprimé comprenant un motif conducteur et une réserve de placage formée sur une couche adhésive sur un substrat, caractérisée en ce que la réserve de placage est formée par cuisson d'une résine époxy non cuite de type novolaque, ayant une structure de formule (1) acrylée à un rapport d'acrylation de 20 à 80% et contenant 2 à 8% en poids, par rapport à la matrice de résine photosensible, d'un agent de cuisson imidazole, et possède un rapport d'absorption d'eau ne dépassant pas 0,1% après cuisson.

Formule(1)

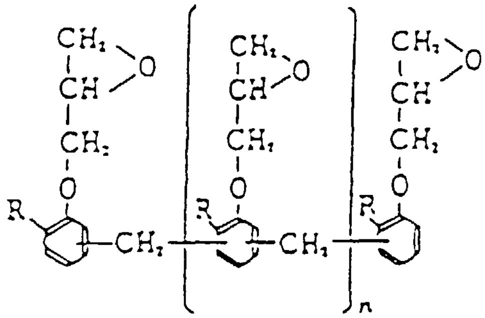

R=H ou $CH_3$

2. Carte à circuit imprimé selon la revendication 1, caractérisée en ce que ladite résine époxy non cuite de type novolaque possède un équivalent époxy ne dépassant pas 300.

FIG_1a

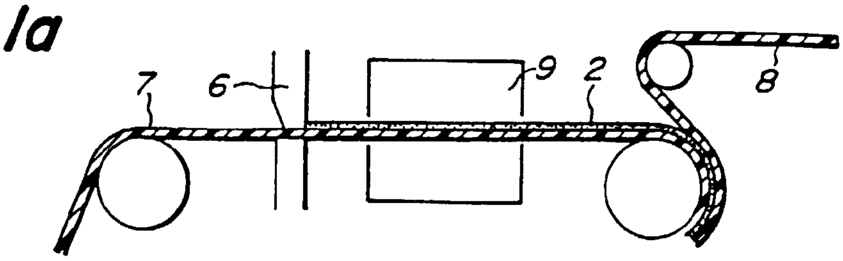


FIG_1b

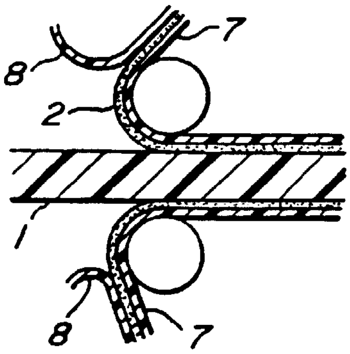


FIG_1c

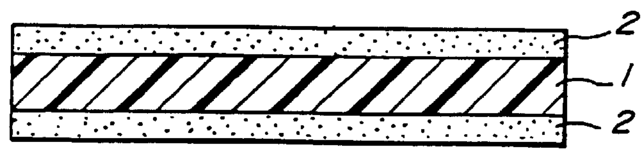


FIG_1d

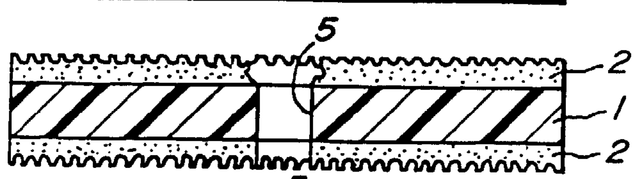


FIG_1e

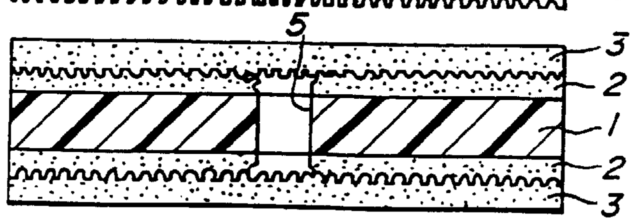


FIG_1f

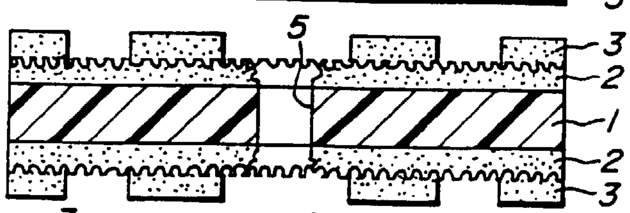


FIG_1g